# DEMANDE DE BREVET EUROPEEN

(11) **EP 1 406 301 A2**
(43) Date de publication de la demande: **07.04.2004**
(21) Numéro de dépôt: 03300058.9
(22) Date de dépôt: 11.07.2003
(51) Int. Cl.: H01L 23/525

(54) **Adaptation d'un circuit intégré à des besoins spécifiques**

(30) Priorité: 12.07.2002 FR 0208860
(71) Demandeur: STMicroelectronics S.A., 92120 Montrouge (FR)
(72) Inventeur: Schoellkopf, M. Jean-Pierre, 38000 Grenoble (FR)
(74) Mandataire: de Beaumont, Michel

(57) **Abrégé**

L'invention concerne un procédé d'adaptation à des besoins spécifiques d'un circuit intégré comprenant un empilement de couches isolantes (10, 14, 18), chaque couche étant associée à un niveau de métallisation déterminé, des zones métalliques du dernier niveau de métallisation formant des contacts électriques du circuit intégré, comprenant les étapes consistant à former des paires de régions métalliques (16A, 16B, 16C, 16D) de l'avant-dernier niveau de métallisation ayant un bord en vis-à-vis et reliées à des composants du circuit intégré ; déposer une couche isolante (22) ; graver en fonction des besoins spécifiques la couche isolante pour exposer les bords en vis-à-vis des régions métalliques (16A, 16B) de paires déterminées ; et former des portions métalliques (28A, 28B) du dernier niveau de métallisation qui recouvrent les bords en vis-à-vis des régions métalliques de toutes les paires et qui contactent les régions métalliques des paires déterminées.

## Description

La présente invention concerne un procédé d'adaptation d'un circuit intégré à des besoins spécifiques. La présente invention concerne également la structure obtenue par ledit procédé.

Lors de la fabrication d'un circuit intégré, il est fréquent de devoir réaliser des adaptations du circuit intégré en fonction de besoins spécifiques formulés par le futur utilisateur du circuit intégré. Par exemple, l'utilisateur peut souhaiter coder dans le circuit intégré des données sous forme de bits qui lui sont propres. De telles données peuvent correspondre à des numéros d'identification du produit sur lequel le circuit intégré est destiné à fonctionner, du lot de plaquettes auquel appartient le circuit intégré, de la plaquette du lot de plaquettes sur laquelle le circuit intégré a été réalisé, de la nature du circuit intégré, etc. Les données peuvent également correspondre à un code constitué de plusieurs bits qui sera utilisé ultérieurement par l'utilisateur par exemple pour la mise en oeuvre d'opérations de cryptage. L'adaptation du circuit intégré peut également consister à prévoir des moyens de correction spécifiques pour éventuellement corriger certaines données stockées dans des mémoires réalisées dans le circuit intégré qui se révèleraient défectueuses lors de tests.

Il est préférable que les opérations d'adaptation soient réalisées aux dernières étapes du procédé de fabrication du circuit intégré. En effet, ceci permet de ne pas modifier la majorité des étapes du procédé de fabrication qui restent communes à tous les circuits intégrés d'une même plaquette quelle que soit leur destination ultérieure. En outre, il est préférable que les étapes d'adaptation du circuit intégré mettent en oeuvre le plus possible des technologies habituelles des filières de semiconducteurs et présentent un faible coût par rapport au coût de fabrication global du circuit intégré.

L'adaptation d'un circuit intégré est couramment réalisée de la façon suivante. Des fusibles constitués de pistes métalliques sont formés au niveau des derniers niveaux de métallisation du circuit intégré. Aux dernières étapes du procédé de fabrication du circuit intégré, et en fonction des besoins de l'usager, certaines des pistes sont ouvertes au moyen d'un faisceau laser. Une borne du fusible peut être destinée, lors du fonctionnement ultérieur du circuit intégré, à être reliée à la masse et l'autre borne à un potentiel élevé. Les fusibles ouverts permettent alors, par exemple, de coder une information correspondant à un bit "1", et les fusibles maintenus intacts de coder une information correspondant à un bit "0". Le fusible peut être également relié à une mémoire, par exemple une mémoire intégrée statique ou dynamique à accès aléatoire (ESRAM ou EDRAM). L'ouverture des fusibles peut alors permettre de corriger la donnée à stocker dans la mémoire si celle-ci se révèle être défectueuse lors de tests conduits aux dernières étapes du procédé de fabrication du circuit intégré.

Un tel procédé d'adaptation de circuit intégré présente certains inconvénients. En effet, l'utilisation d'un faisceau laser nécessite des précautions particulières. Plus précisément, chaque piste métallique correspondant à un fusible doit avoir généralement une longueur d'au moins 10 micromètres et être éloignée d'autres pistes métalliques d'au moins 50 micromètres pour que l'ouverture de la piste par le faisceau laser n'abîme pas les pistes voisines. La densité surfacique des pistes métalliques est donc limitée et la surface nécessaire au codage de données peut alors être importante d'autant plus que les données couramment codées peuvent comprendre plus de 100 bits. La surface minimale requise étant liée à la technologie laser, elle ne peut être diminuée quelles que soient les technologies de filières de semiconducteurs utilisées par ailleurs.

En outre, il n'est généralement pas réalisé de dépôt, par exemple d'une couche de passivation épaisse, sur le circuit intégré une fois l'opération d'ouverture des fusibles effectuée. Ceci signifie qu'une observation de la surface du circuit intégré permet de distinguer quels fusibles ont été ouverts par le faisceau laser. L'identification de l'information codée sur le circuit intégré peut en être facilitée, ce qui peut ne pas être souhaitable.

La présente invention vise à proposer un procédé d'adaptation d'un circuit intégré à des besoins spécifiques mis en oeuvre aux dernières étapes du procédé de fabrication du circuit intégré, ayant un faible coût de réalisation et nécessitant une surface de circuit intégré inférieure à celle utilisée par des procédés classiques.

La présente invention vise également à obtenir un procédé d'adaptation d'un circuit intégré pour lequel la structure obtenue ne fournit pas d'indice visuel quant à la nature de l'adaptation réalisée.

Dans ce but, elle prévoit un procédé d'adaptation à des besoins spécifiques d'un circuit intégré comprenant un empilement de couches isolantes, chaque couche étant associée à un niveau de métallisation déterminé, des zones métalliques du dernier niveau de métallisation formant des contacts électriques du circuit intégré, comprenant les étapes consistant à : (a) former des paires de régions métalliques de l'avant-dernier niveau de métallisation ayant un bord en vis-à-vis et reliées à des composants du circuit intégré ; (b) déposer une couche isolante ; (c) graver en fonction des besoins spécifiques la couche isolante pour exposer les bords en vis-à-vis des régions métalliques de paires déterminées ; et (d) former des portions métalliques du dernier niveau de métallisation qui recouvrent les bords en vis-à-vis des régions métalliques de toutes les paires et qui contactent les régions métalliques des paires déterminées.

Selon un mode de réalisation de l'invention, l'étape (d) consiste à déposer une couche métallique du dernier niveau de métallisation, et à délimiter dans la couche métallique les portions métalliques.

Selon un mode de réalisation de l'invention, les zones métalliques sont délimitées dans la couche métallique simultanément aux portions métalliques.

Selon un mode de réalisation de l'invention, le procédé comprend en outre les étapes consistant à déposer une couche de passivation ; et graver des ouvertures exposant les zones métalliques.

Selon un mode de réalisation de l'invention, la gravure de la couche isolante est une gravure directe par un faisceau d'électrons.

Selon un mode de réalisation de l'invention, les portions métalliques sont des billes métalliques de connexion.

La présente invention concerne également un circuit intégré adapté à des besoins spécifiques, comprenant un empilement de couches isolantes, chaque couche étant associée à un niveau de métallisation déterminé, des zones métalliques du dernier niveau de métallisation formant des contacts électriques du circuit intégré, comprenant des paires de régions métalliques de l'avant-dernier niveau de métallisation ayant un bord en vis-à-vis et reliées à des composants du circuit intégré ; des portions isolantes recouvrant les bords des régions métalliques de paires déterminées en fonction des besoins spécifiques ; et des portions métalliques du dernier niveau de métallisation recouvrant les bords en vis-à-vis des régions métalliques de toutes les paires et reliant les régions métalliques des paires autres que les paires déterminées.

Selon un mode de réalisation de l'invention, le circuit comprend en outre une couche de passivation recouvrant les portions métalliques.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
les figures 1A à 1E représentent des coupes d'une portion d'un circuit intégré à des étapes successives d'un premier mode de réalisation du procédé d'adaptation selon l'invention ; et
la figure 2 représente une coupe d'un circuit intégré obtenu par un deuxième mode de réalisation du procédé selon l'invention.

On va décrire de façon détaillée deux modes de réalisation du procédé selon la présente invention. On notera que dans les différentes figures, comme cela est usuel dans le domaine de la représentation des circuits intégrés, les épaisseurs et dimensions latérales des diverses couches ne sont pas tracées à l'échelle ni à l'intérieur d'une même figure, ni d'une figure à l'autre pour améliorer la visibilité de cette figure. Par ailleurs, de mêmes références désigneront, sur les différentes figures, de mêmes éléments.

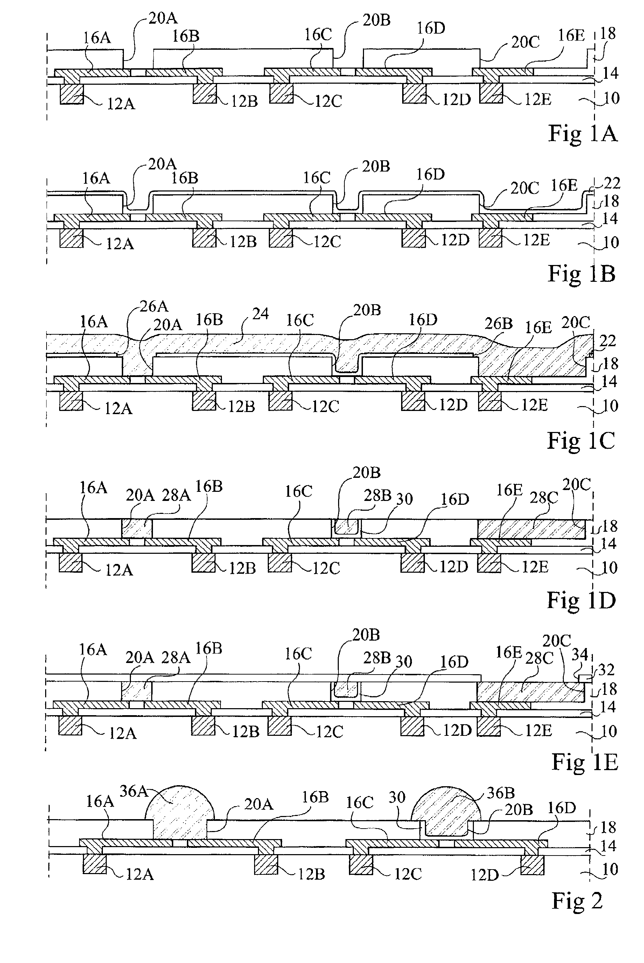

La figure 1A représente une coupe d'une portion d'un circuit intégré au niveau des derniers niveaux de métallisation. Le circuit intégré comprend une couche isolante 10, par exemple en oxyde de silicium, comportant des portions métalliques 12A à 12E, par exemple en cuivre ou en aluminium, appartenant à l'avant-avant-dernier niveau de métallisation. Les portions métalliques 12A à 12E correspondent par exemple à des pistes ou à des vias connectés à des composants non représentés réalisés dans le circuit intégré. Une couche intermétallique isolante 14, par exemple en oxyde de silicium, recouvre la couche isolante 10. Des régions métalliques 16A à 16E, appartenant à l'avant-dernier niveau de métallisation, et constituées par exemple de cuivre ou d'aluminium, s'étendent sur la couche intermétallique 14. Les régions métalliques 16A à 16E sont reliées respectivement aux portions métalliques 12A à 12E au travers de la couche intermétallique 14. Les régions métalliques 16A à 16E sont réparties en une région métallique 16E et en deux paires de régions métalliques 16A, 16B et 16C, 16D, deux régions métalliques d'une même paire ayant un bord en vis-à-vis. Le circuit intégré comprend plusieurs autres paires de régions métalliques, non représentées, analogues aux paires de régions métalliques 16A à 16D, ainsi que d'autres régions métalliques, non représentées, analogues à la région métallique 16E. Chaque paire de régions métalliques 16A à 16D forme un "anti-fusible", c'est-à-dire un composant qui à l'état "non modifié" est équivalent à un interrupteur ouvert, et qui à l'état "modifié" est équivalent à un interrupteur fermé.

Une couche de diélectrique 18, par exemple en nitrure de silicium, recouvre les régions métalliques 16A à 16E et la couche intermétallique 14. Des ouvertures 20A, 20B, 20C réalisées dans la couche diélectrique 18 exposent une partie de la région métallique 16E et les bords en vis-à-vis des régions métalliques 16A à 16D des paires métalliques.

La figure 1B représente la structure obtenue après le dépôt d'une couche mince isolante 22 sur la couche diélectrique 18, réalisée par exemple par un dépôt conforme d'oxyde de silicium.

La figure 1C représente la structure obtenue après la gravure d'évidements 26A, 26B dans la couche mince 22 et le dépôt d'une couche métallique 24, par exemple en cuivre ou en aluminium, sur l'ensemble du circuit intégré. De préférence, la couche mince 22 est directement gravée par un faisceau d'électrons. Les évidements 26A, 26B sont gravées dans la couche mince 22, au niveau des ouvertures 20A et 20C de la couche diélectrique 18, pour exposer les bords en vis-à-vis des régions métalliques 16A, 16B et la région métallique 16E. La couche métallique 24 est ainsi électriquement reliée aux régions métalliques 16A, 16B, 16E et pas aux régions 16C et 16D.

La figure 1D représente la structure obtenue après réalisation d'une étape de planarisation, par exemple par polissage mécano chimique assurant une gravure de la couche métallique 24 et de la couche mince 22 jusqu'à la surface de la couche diélectrique 18. On délimite ainsi des portions métalliques 28A, 28B, 28C dans les ouvertures 20A à 20C de la couche diélectrique 18. Dans les ouvertures 20A, 20C où la couche mince 22 a été gravée, les portions métalliques 28A, 28C sont en contact avec les régions métalliques 16A, 16B, 16E. Dans l'ouverture 20B où la couche mince 22 n'a pas été gravée, la portion métallique 28B est séparée des régions métalliques 16C, 16D par une portion isolante 30.

La figure 1E représente la structure obtenue après le dépôt d'une couche de passivation 32 et la gravure dans la couche de passivation 32 d'une ouverture 34 exposant la portion métallique 28C. La portion métallique 28C forme un plot de contact. Des fils de connexion pourront être soudés à ce plot.

La portion métallique 28A réalise une liaison électrique entre les régions métalliques 16A, 16B, et ainsi ferme "l'anti-fusible" correspondant. A titre d'exemple, dans le cas où la portion métallique 16A est reliée à la masse et la portion métallique 16B est reliée à un potentiel élevé via une résistance, l'information codée correspond à un bit "0".

De façon analogue, les régions métalliques 16C, 16D demeurent isolées l'une de l'autre et forment donc un anti-fusible ouvert. Dans le cas où l'une des régions métalliques est connectée à la masse et l'autre à un potentiel élevé, l'information codée correspond à un bit "1".

La présente invention consiste donc à réaliser des anti-fusibles constitués de paires de régions métalliques dans l'avant-dernier niveau de métallisation dont des bords sont en vis-à-vis, et que l'on maintient ouvert ou que l'on ferme aux dernières étapes du procédé de fabrication du circuit intégré en fonction des besoins spécifiques de l'utilisateur du circuit. Comme cela apparaît sur les figures 1A à 1E, le procédé selon l'invention permet la réalisation et la fermeture sélective des anti-fusibles en parallèle avec la réalisation des contacts du circuit intégré.

La figure 2 représente une coupe d'un circuit intégré obtenu selon un second mode de réalisation de l'invention, seuls deux anti-fusibles étant représentés. Dans le second mode, après des étapes similaires à celles représentées sur les figures 1A et 1B, on grave la couche mince 22 au niveau de l'ouverture 20A, et on forme dans toutes les ouvertures des billes de contact 36A, 36B, par exemple à base d'étain-plomb. Les billes 36A, 36B sont destinées à la fixation directe du circuit intégré sur un substrat extérieur selon la technologie dite "flip chip". La bille 36A assure la connexion entre les régions métalliques 16A et 16B, l'anti-fusible correspondant étant donc fermé. La bille 36B est séparée des régions métalliques 16C et 16D par une portion isolante 30, l'anti-fusible correspondant restant donc ouvert.

Les billes 36A, 36B sont destinées à réaliser seulement la connexion mécanique entre le circuit intégré et le substrat sur lequel le circuit intégré doit être fixé, mais ne sont pas destinées à être connectées électriquement au substrat extérieur sur lequel le circuit intégré est fixé. Des billes de connexion (non représentées), connectées à des régions correspondant à la région 16E de la figure 1 assurent la liaison électrique et mécanique entre le circuit intégré et le substrat extérieur.

La présente invention comporte de nombreux avantages.

Premièrement, elle permet d'adapter facilement un circuit intégré à des besoins spécifiques par la fermeture d'anti-fusibles réalisés dans le circuit intégré, l'étape de fermeture des anti-fusibles étant réalisée aux dernières étapes du procédé de fabrication du circuit intégré.

Deuxièmement, dans le premier mode de réalisation selon l'invention, la densité surfacique des anti-fusibles peut être élevée puisque les procédés mis en oeuvre pour leur réalisation et leur fermeture éventuelle sont des procédés classiques des filières de semiconducteurs. Dans le second mode de réalisation de l'invention, la densité surfacique des anti-fusibles est limitée à la densité surfacique que l'on peut obtenir pour les billes de connexion.

Troisièmement, la gravure de la couche mince isolante peut être réalisée directement par un faisceau d'électrons piloté par un ordinateur. La gravure par un faisceau d'électrons est typiquement plus lente qu'une gravure mettant en oeuvre un masque. En effet, le faisceau d'électrons grave successivement les différentes zones de la couche isolante correspondant aux anti-fusibles à fermer. Toutefois, étant donné le nombre relativement faible de zones à graver, ceci n'est pas préjudiciable. En outre, l'utilisation d'un faisceau d'électrons programmable est plus économique qu'une gravure nécessitant la réalisation d'un masque.

Quatrièmement, la structure obtenue par le présent procédé ne permet pas de déceler par une simple observation visuelle si les anti-fusibles sont ouverts ou fermés.

Cinquièmement, dans le premier mode de réalisation, la réalisation des anti-fusibles est compatible avec la réalisation des plots de contact du circuit intégré, et dans le deuxième mode de réalisation avec la réalisation des billes de connexion.

Bien entendu, la présente invention est susceptible de diverses variantes et modifications qui apparaîtront à l'homme de l'art. En particulier, les différentes couches isolantes et les différentes parties métalliques peuvent être constituées de tout matériau adapté.

## Revendications

1. Procédé d'adaptation à des besoins spécifiques d'un circuit intégré comprenant un empilement de couches isolantes (10, 14, 18), chaque couche étant associée à un niveau de métallisation déterminé, des zones métalliques du dernier niveau de métallisation formant des contacts électriques du circuit intégré, **caractérisé en ce qu'**il comprend les étapes suivantes :
(a) former des paires de régions métalliques (16A, 16B, 16C, 16D) de l'avant-dernier niveau de métallisation ayant un bord en vis-à-vis et reliées à des composants du circuit intégré ;
(b) déposer une couche isolante (22) ;
(c) graver en fonction des besoins spécifiques la couche isolante pour exposer les bords en vis-à-vis des régions métalliques (16A, 16B) de paires déterminées ; et
(d) former des portions métalliques (28A, 28B ; 36A, 36B) du dernier niveau de métallisation qui recouvrent les bords en vis-à-vis des régions métalliques de toutes les paires et qui contactent les régions métalliques des paires déterminées.

2. Procédé selon la revendication 1, dans lequel l'étape (d) consiste à déposer une couche métallique (24) du dernier niveau de métallisation, et à délimiter dans la couche métallique les portions métalliques (28A, 28B ; 36A, 36B).

3. Procédé selon la revendication 2, dans lequel les zones métalliques (28C) sont délimitées dans la couche métallique (24) simultanément aux portions métalliques (28A, 28B ; 36A, 36B).

4. Procédé selon la revendication 3, comprenant en outre les étapes suivantes :
déposer une couche de passivation (32) ; et
graver des ouvertures (34) exposant les zones métalliques (28C) .

5. Procédé selon la revendication 1, dans lequel la gravure de la couche isolante (22) est une gravure directe par un faisceau d'électrons.

6. Procédé selon la revendication 1, dans lequel les portions métalliques (36A, 36B) sont des billes métalliques de connexion.

7. Circuit intégré adapté à des besoins spécifiques, comprenant un empilement de couches isolantes (10, 14, 18), chaque couche étant associée à un niveau de métallisation déterminé, des zones métalliques (28C, 36A, 36B) du dernier niveau de métallisation formant des contacts électriques du circuit intégré, **caractérisé en ce qu'**il comprend :
des paires de régions métalliques (16A, 16B, 16C, 16D) de l'avant-dernier niveau de métallisation ayant un bord en vis-à-vis et reliées à des composants du circuit intégré ;
des portions isolantes (30) recouvrant les bords des régions métalliques (16C, 16D) de paires déterminées en fonction des besoins spécifiques ; et
des portions métalliques (28A, 28B, 36A, 36B) du dernier niveau de métallisation recouvrant les bords en vis-à-vis des régions métalliques de toutes les paires et reliant les régions métalliques (16A, 16B) des paires autres que les paires déterminées.

8. Circuit intégré selon la revendication 7, comprenant en outre une couche de passivation (32) recouvrant les portions métalliques (28A, 28B, 36A, 36B).
